(19) Europäisches Patentamt / European Patent Office / Office européen des brevets

(11) **EP 2 690 154 A1**

(12) **EUROPEAN PATENT APPLICATION**

(43) Date of publication:
**29.01.2014 Bulletin 2014/05**

(51) Int Cl.:
***C09K 11/77*** *(2006.01)*

(21) Application number: **13177462.2**

(22) Date of filing: **22.07.2013**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority: **24.07.2012 JP 2012163297**

(71) Applicant: **Shin-Etsu Chemical Co., Ltd.
Chiyoda-ku,
Tokyo (JP)**

(72) Inventors:
• **Kawazoe, Hirofumi
Fukui-ken (JP)**
• **Wataya, Kazuhiro
Fukui-ken (JP)**

(74) Representative: **Stuart, Ian Alexander et al
Mewburn Ellis LLP
33 Gutter Lane
London
EC2V 8AS (GB)**

(54) **Method for preparing phosphor precursor and phosphor, and wavelength converter**

(57) Intended is a phosphor of the formula: $(A_{1-x}B_x)_3C_5O_{12}$ wherein A is Y, Gd, and/or Lu, B is Ce and/or Tb, C is Al and/or Ga, and $0.002 \leq x \leq 0.2$. A phosphor precursor is prepared by suspending gamma-alumina particles having a specific surface area of at least $50 \ m^2/g$ and dissolving a rare earth element salt in water to form a suspended aqueous solution, adding urea thereto, heating the solution to form mixed fine particles of gamma-alumina and rare earth element salt, separating, and firing the mixed fine particles at 600-1,000°C to form mixed oxide fine particles of rare earth oxide and alumina.

EP 2 690 154 A1

**Description**

**TECHNICAL FIELD**

This invention relates to a method for preparing a precursor to a garnet structure phosphor, a method for preparing a phosphor, and a wavelength converter using the phosphor.

**BACKGROUND ART**

Light-emitting diodes (LEDs) are the most efficient among currently available light sources. In particular, white LEDs find a rapidly expanding share in the market as the next-generation light source to replace incandescent lamps, fluorescent lamps, cold cathode fluorescent lamps (CCFL), and halogen lamps. Of the white LEDs, pseudo-white LEDs are arrived at by combining a blue LED with a phosphor capable of yellow or green emission upon blue light excitation.
Suitable phosphors used therein include phosphors of yellow or yellow orange emission such as $Y_3Al_5O_{12}$:Ce, $(Y,Gd)_3(Al,Ga)_5O_{12}$:Ce, and $(Y,Gd)_3Al_5O_{12}$:Ce, and phosphors of green or green yellow emission such as $Lu_3Al_5O_{12}$: Ce and $Lu_3(Al,Ga)_5O_{12}$:Ce.
These phosphors are prepared by various methods. For example, JP 3700502 discloses a method for preparing a phosphor by dissolving rare earth elements Y, Gd and Ce in a proper stoichiometric ratio in an acid, coprecipitating the solution with oxalic acid, firing the coprecipitate into coprecipitate oxide, mixing it with aluminum oxide, and adding ammonium fluoride as flux thereto. The mixture is placed in a crucible and fired in air at 1,400°C for 3 hours. The fired material is wet milled on a ball mill, washed, separated, dried, and finally sieved.
JP-A 2005-008844 describes a method of preparing a phosphor by mixing lutetium oxide, cerium oxide and alumina as phosphor-providing materials in a stoichiometric ratio, adding barium fluoride as flux, thoroughly mixing them, feeding the mixture into a crucible, firing in a hydrogen/nitrogen gas mixed atmosphere having a hydrogen concentration of up to 3% by volume at a temperature of 1,400°C for 3 hours, wet milling the fired product on a ball mill, washing, separating, drying, and sieving.

**Citation List**

Patent Document 1: JP 3700502
Patent Document 2: JP-A 2005-008844

**DISCLOSURE OF INVENTION**

The methods of Patent Documents 1 and 2 start with the phosphor-providing raw materials or precursors of oxide form having a size in the range from submicron to several microns. When such raw materials are mixed, the resulting mixture is not regarded as a homogeneous mixture in view of the size of phosphor particles prepared therefrom. Undesirably, the phosphor prepared from these raw materials is likely to invite a compositional variation between phosphor particles.
Preferred embodiments of the invention may provide a method for preparing a phosphor precursor from which phosphor particles of a more uniform composition are derived, a method for preparing a phosphor from the precursor, and a wavelength converter using the phosphor prepared by the method.
The inventors have found that by adding urea to an aqueous solution of rare earth element salt having gamma-alumina particles having a BET specific surface area of at least 50 m²/g suspended therein, heating the solution to form a precipitate, separating the precipitate from the suspension, and firing the precipitate, there is obtained an oxide material in a uniformly mixed state as compared with conventional powder mixtures; and that using the oxide material as phosphor-providing raw material, a phosphor can be prepared in the form of particles which are more uniform in composition.
In a first aspect, the invention provides a method for preparing a precursor to a phosphor comprising a garnet phase of the compositional formula (1):

$$(A_{1-x}B_x)_3C_5O_{12} \qquad (1)$$

wherein A is at least one rare earth element selected from the group consisting of Y, Gd, and Lu, B is Ce and/or Tb, C is Al and/or Ga, and $0.002 \leq x \leq 0.2$, the method comprising the steps of:

suspending gamma-alumina particles having a BET specific surface area of at least 50 m$^2$/g and dissolving a rare earth element salt in water to form a suspended aqueous solution,

adding urea to the suspended aqueous solution,

heating the solution to form mixed fine particles of gamma-alumina and rare earth element salt,

separating the mixed fine particles from the solution after heating, and

firing the mixed fine particles at a temperature of up to 1,000°C to form mixed oxide fine particles of rare earth oxide and alumina.

In a preferred embodiment, the rare earth element salt used in the dissolving step contains a salt of Y, Gd and/or Lu, a salt of Ce and/or Tb, and optionally, a salt of Ga.

In a second aspect, the invention provides a method for preparing a phosphor, comprising the steps of combining the mixed oxide fine particles prepared by the first method with a flux, and heating the resulting mixture in a reducing atmosphere at a temperature of 1,300 to 1,500°C.

In a third aspect, the invention provides a method for preparing a phosphor, comprising the steps of granulating the mixed oxide fine particles prepared by the first method, melting the resulting granules in plasma and solidifying, and heating the resulting particles in a reducing atmosphere.

In a fourth aspect, the invention provides a wavelength converter comprising the phosphor obtained as above and an organic resin in admixture.

## ADVANTAGEOUS EFFECTS OF PREFERRED EMBODIMENTS

Since gamma-alumina particles having a large specific surface area become nuclei and a precipitate of rare earth element salt deposits on surfaces thereof, particles of finer size precipitate out. The mixed oxide fine particles (phosphor precursor) are in a uniformly mixed state as compared with conventional powder mixtures. As a result, a phosphor of uniform composition is available.

## BRIEF DESCRIPTION OF DRAWINGS

FIG. 1 is a set of images showing analytical results of mixed oxide fine particles in Example 1 by EPMA, FIG. 1A being a secondary electron image, FIG. 1B being a back-scattering electron image, FIG. 1C showing distributions of Y, Ce, Al and O.

FIG. 2 is a set of images showing analytical results of mixed oxide fine particles in Comparative Example 1 by EPMA, FIG. 2A being a secondary electron image, FIG. 2B being a back-scattering electron image, FIG. 2C showing distributions of Y, Ce, Al and O.

## DESCRIPTION OF PREFERRED EMBODIMENTS

One embodiment of the invention is a method for preparing a precursor to a phosphor comprising a garnet phase of the compositional formula (1):

$$(A_{1-x}B_x)_3C_5O_{12} \qquad (1)$$

wherein A is at least one rare earth element selected from the group consisting of yttrium (Y), gadolinium (Gd), and lutetium (Lu), B is cerium (Ce) and/or terbium (Tb), x is in the range: $0.002 \leq x \leq 0.2$, and C is aluminum (Al) and/or gallium (Ga). The method involves the steps of suspending gamma-alumina particles having a BET specific surface area of at least 50 m$^2$/g and dissolving a rare earth element salt in water to form a suspended aqueous solution, adding urea to the suspended aqueous solution, heating the solution to form mixed fine particles of gamma-alumina and rare earth element salt, separating the mixed fine particles from the suspended aqueous solution after heating, and firing the mixed fine particles at a temperature of up to 1,000°C to form mixed oxide fine particles of rare earth oxide and alumina.

## Preparation of phosphor precursor

The method for preparing a phosphor precursor includes the following steps.

(1) Preparation of suspended aqueous solution

First, a suspended aqueous solution is prepared by suspending gamma-alumina particles having a BET specific surface area of at least 50 $m^2/g$ and dissolving a rare earth element salt in water.

While gamma-alumina particles are suspended in water to form a suspension, they should have a BET specific surface area of at least 50 $m^2/g$, preferably at least 100 $m^2/g$. A surface area of less than 50 $m^2/g$ indicates alumina particles having a relatively large particle size, from which mixed fine particles having uniform distribution of constituent elements are obtainable with difficulty.

To the suspension, a rare earth element salt is admitted. The rare earth element salt should preferably contain a salt of at least one rare earth element selected from Y, Gd and Lu and a salt of Ce and/or Tb. Optionally, the rare earth element salt further contains a salt of Ga. Suitable salts include nitrates, chlorides, sulfates and acetates.

Generally, gamma-alumina particles and the rare earth element salt are combined in a ratio corresponding to the desired phosphor composition. The solution preferably contains the rare earth element salt in a concentration of 0.03 mole/L to 0.3 mole/L. The rare earth element salt may be admitted in salt form or aqueous solution form and at any desired timing before or after admission of gamma-alumina particles.

(2) Formation and separation of mixed fine particles

Urea is added to the suspended aqueous solution. The amount of urea added is preferably 8 to 30 times, more preferably 10 to 20 times the moles of the rare earth element salt in the solution. If the amount of urea added is less than 8 times the moles of the rare earth element salt, the rare earth element precipitate may be recovered in lower yields, with the composition thereof deviating from the desired one. An amount of urea in excess of 30 times may be uneconomical.

The solution is then heated at a temperature between 80°C and its boiling point whereby urea is hydrolyzed and the rare earth element salt precipitates out. The precipitate of rare earth element salt deposits on surfaces of gamma-alumina particles as nuclei. The precipitation mechanism is described below although it differs with a precipitating material and a nuclear material. In an example where a basic carbonate salt of yttrium (Y) or cerium (Ce) is precipitated on gamma-alumina particles, the gamma-alumina particles act as nuclei for precipitate growth. If a basic carbonate salt of Y or Ce is precipitated in the absence of suspended gamma-alumina particles, the salt is precipitated as particles having a particle size (for example, an average particle size of about 0.2 to 1.0 $\mu$m, and a specific surface area of about 2 to 10 $m^2/g$ when fired at 800°C for 4 hours) which is about 10 times larger than the size available in the presence of suspended gamma-alumina particles. In view of this fact, gamma-alumina particles act as nuclei for precipitate growth, with the aid of which the precipitate is fine-grained. As a result, mixed fine particles having a large surface area are obtainable.

As gamma-alumina particles suspended are of finer size, a precipitate product in a more uniformly mixed state is obtainable. For this reason, better results are obtained from gamma-alumina particles having a greater specific surface area. Specifically, gamma-alumina particles should have a surface area of at least 50 $m^2/g$, preferably at least 100 $m^2/g$. A surface area of less than 50 $m^2/g$ indicates relatively large alumina particles, from which mixed fine particles of larger size are obtainable and hence, in less uniformly mixed state.

Finally, only the mixed fine particles are taken out of the aqueous solution by solid-liquid separation. Suitable solid-liquid separation may be filtration, centrifugation or the like. In this way, the mixed fine particles are obtained as a precipitate in a more uniformly mixed state than conventional powder mixtures.

(3) Formation of mixed oxide fine particles

The mixed fine particles are then fired in air, yielding mixed oxide fine particles. The firing temperature is arbitrary as long as the salt in the precipitate can be decomposed, but is typically in the range of 600°C to 1,000°C. A mixed powder (mixed oxide fine particles), in which constituents are uniformly mixed as compared with conventional powder mixtures commonly used in the phosphor manufacture, is obtained as phosphor precursor (or phosphor-providing raw material).

As is well known in the art, an element serving as luminescent center, known as activator, is generally incorporated in phosphor material. In the invention, element B (i.e., Ce or Tb) in formula (1) corresponds to this element. It is believed that if the element serving as luminescent center has a deviation within one phosphor particle or between phosphor particles, phosphor properties are deteriorated. As compared with conventional powder mixtures, the raw material powder (mixed oxide fine particles) of the invention has a uniform distribution of the activator element. The phosphor prepared from this raw material powder exhibits better properties because of a likelihood that the activator is uniformly incorporated in phosphor particles.

**Preparation of phosphor**

In another embodiment, a phosphor is prepared using the mixed oxide fine particles resulting from the above method as the phosphor precursor. The phosphor may be prepared in the following two ways, for example.

(4-1) In one method, a phosphor is prepared by combining the mixed oxide fine particles with a flux, and heating the resulting mixture in a reducing atmosphere at a temperature of 1,300°C to 1,500°C for 10 minutes to 4 hours. The flux used herein may be barium fluoride or ammonium fluoride. The amount of the flux mixed is preferably 1 to 30% by weight based on the mixed oxide fine particles. The heating step is in a reducing atmosphere, typically a gas mixture of argon or nitrogen and 1 to 8% by volume of hydrogen gas. The product as heated is then washed in dilute acid or deionized water to remove the flux component, whereupon it is ready for use as phosphor.
(4-2) In the other method, a phosphor is prepared by granulating the mixed oxide fine particles on a granulator. Suitable granulators include a tumbling granulator and spray drier. Any desired granulator may be used as long as granules having an approximate size to the particle size of the desired phosphor are obtained. On granulation, an organic binder and/or dispersant may be mixed for the purpose of enhancing the bond and fluidity of granulated powder. The granulated powder may be fired at a temperature of 1,000 to 1,700°C, if necessary, for the purposes of removing any organic matter and increasing the density of the granulated powder. Next, the granulated powder is melted by passing through a hot plasma gas and then cooled and solidified in air or an inert atmosphere. The resulting particles are heated in a reducing atmosphere, yielding phosphor particles.

The phosphor particles obtained by either of the methods exhibit better properties because constituent elements are more uniformly mixed than in the phosphor obtained from a mixture of starting powders of constituent elements.
The phosphor thus prepared is suitable as a phosphor for wavelength conversion of light from a light-emitter in LED. The phosphor finds use in LEDs as well as illuminating devices and backlight sources using the same. Specifically, the phosphor is mixed with an organic resin to form a resin composition, which is molded into a wavelength converter for wavelength conversion of light from a light-emitter in LED.

**EXAMPLE**

Examples and Comparative Examples are given below by way of illustration and not by way of limitation. The average particle size is a median diameter as measured by the laser light diffractometry. The specific surface area is measured by the BET method.

**Example 1**

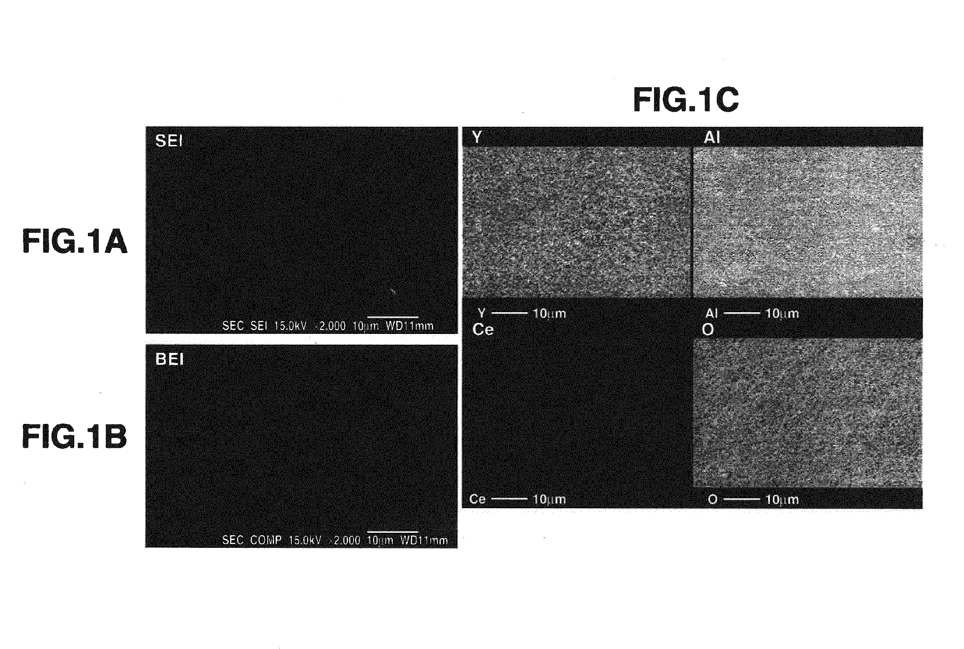

With mixing, 9,800 g of gamma-alumina particles having a specific surface area of about 230 $m^2$/g and a purity of 99.99% was suspended in 1,000 L of deionized water. This suspension was combined with 113 moles of 99.99% pure yttrium nitrate and 2.3 moles of 99.99% pure cerium nitrate to form a suspended aqueous solution. With mixing, 80,000 g of urea having a purity of at least 99.9% was dissolved in the suspended aqueous solution. The resulting suspended aqueous solution was heated at 95°C for about 3 hours whereupon 65,000 g of solids (mixed fine particles) was collected by solid-liquid separation. The liquid left after the solid-liquid separation was analyzed for rare earth element concentration, indicating that at least 99% of the rare earth elements separated and deposited as precipitate.
The solid was fired in air at 800°C, obtaining 22,700 g of mixed oxide fine particles. A X-ray diffraction (XRD) analysis of the mixed oxide fine particles revealed that  cerium and yttrium were combined as eutectic crystals while these rare earth element oxides were not composited with alumina. The oxide mixture was shaped into a compact, which was analyzed for distribution of respective elements (Y, Ce, Al, O) by electron probe microanalyzer (EPMA). The results of analysis are shown in FIG. 1. A uniform distribution of the respective elements, especially cerium serving as activator is evident from FIG. 1.
In a mortar, 100 g of the powder mixture (mixed oxide fine particles) thus obtained and 5 g of barium fluoride were thoroughly mixed. The mixture was fed into an alumina crucible which was heated in an atmosphere of a hydrogen/ nitrogen mixture having a hydrogen concentration of up to 3% by volume from room temperature to 1,400°C at a rate of 300°C/hr and held at 1,400°C for 5 hours. The fired product was disintegrated in water using a ball mill, pickled, and washed with water, yielding phosphor particles having an average particle size of 16.6 $\mu$m.
The phosphor particles were measured for absorptivity, internal quantum efficiency, external quantum efficiency, and chromaticity (x and y) by a quantum efficiency measuring system QE1100 (Otsuka Electronics Co., Ltd.) using excitation light 450 nm, emission spectrum of 480 to 740 nm and an integrating hemisphere. The measurement results are shown in Table 1, indicating high values of absorptivity and quantum efficiency.

### Example 2

With mixing, 9,800 g of gamma-alumina particles having a specific surface area of about 235 m$^2$/g and a purity of 99.99% was suspended in 1,000 L of deionized water. This suspension was combined with 102.8 moles of 99.99% pure lutetium nitrate and 2.1 moles of 99.99% pure cerium nitrate to form a suspended aqueous solution. With mixing, 80,000 g of urea having a purity of at least 99.9% was dissolved in the suspended aqueous solution. The resulting suspended aqueous solution was heated at 95°C for about 3 hours whereupon 69,000 g of solids (mixed fine particles) was collected by solid-liquid separation. The liquid left after the solid-liquid separation was analyzed for rare earth element concentration, indicating that at least 99% of the rare earth elements separated and deposited as precipitate.

The solid was fired in air at 800°C, obtaining 30,500 g of mixed oxide fine particles. XRD analysis of the mixed oxide fine particles revealed that cerium and lutetium were combined as eutectic crystals while these rare earth element oxides were not composited with alumina.

The resulting powder (mixed oxide fine particles), 1,000 g, was combined with 3,000 g of deionized water, granulated by a granulator, and fired, obtaining a granulated powder having an average particle size of 20 μm. The granulated powder was melted in an argon plasma and solidified. The resulting powder was heated in a reducing atmosphere consisting of 5 vol% of hydrogen and 95 vol% of argon at 1,500°C for 2 hours, yielding phosphor particles.

The phosphor particles were measured for absorptivity, internal quantum efficiency, external quantum efficiency, and chromaticity (x and y) by a quantum efficiency measuring system QE1100 (Otsuka Electronics Co., Ltd.) using excitation light 450 nm, emission spectrum of 480 to 740 nm and an integrating hemisphere. The measurement results are shown in Table 1, indicating high values of absorptivity and quantum efficiency.

### Comparative Example 1

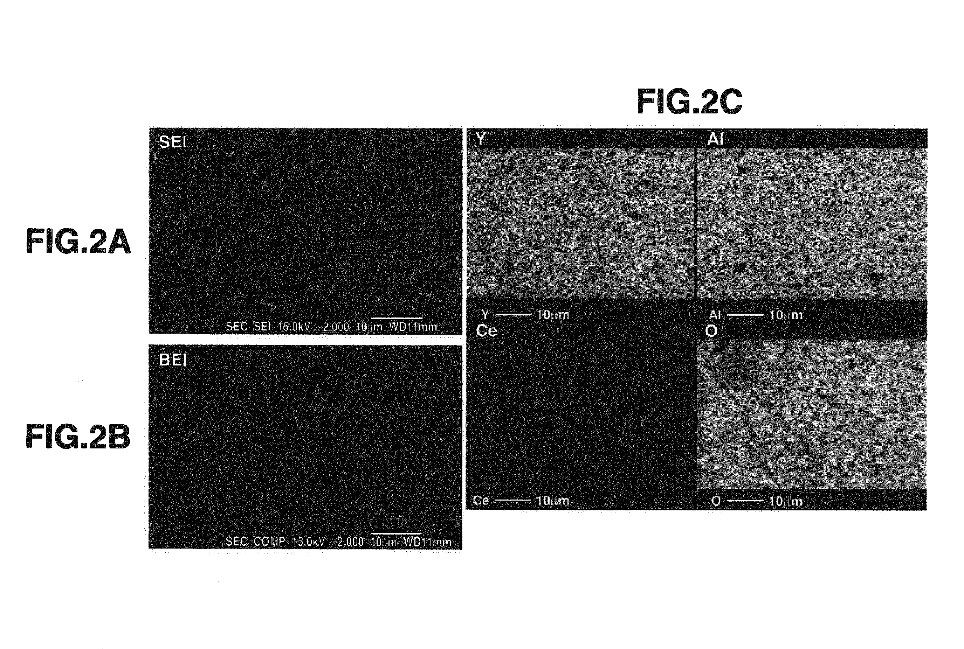

Yttrium oxide powder having a purity of 99.9% and an average particle size of 1.0 μm, aluminum oxide powder having a purity of 99.9% and an average particle size of 0.5 μm, and cerium oxide powder having a purity of 99.9% and an average particle size of 0.2 μm were mixed in a molar ratio of 2.97:5:0.06, yielding 1,000 g of a powder mixture. This oxide mixture was shaped into a compact, which was analyzed for distribution of respective elements (Y, Ce, Al, O) by EPMA. The results of analysis are shown in FIG. 2. Segregation of the respective elements, especially cerium serving as activator is evident from FIG. 2, in stark contrast to FIG. 1.

To 10 g of the resulting powder mixture was added 0.5 g of barium fluoride as flux. After thorough mixing, the mixture was fed into an alumina crucible, heated in an atmosphere of a hydrogen/nitrogen gas mixture having a hydrogen concentration of up to 3% by volume from room temperature to 1,400°C at a rate of 300°C/hr and held at 1,400°C for 5 hours. The fired product was disintegrated in water using a ball mill, washed with water, separated, dried, and classified, yielding phosphor particles.

The phosphor particles were measured for absorptivity, internal quantum efficiency, external quantum efficiency, and chromaticity (x and y) by a quantum efficiency measuring system QE1100 (Otsuka Electronics Co., Ltd.) using excitation light 450 nm, emission spectrum of 480 to 740 nm and an integrating hemisphere. The measurement results are shown in Table 1, indicating somewhat low values as compared with Example 1.

### Comparative Example 2

Lutetium oxide powder having a purity of 99.9% and an average particle size of 1.0 μm, aluminum oxide powder having a purity of 99.9% and an average particle size of 0.5 μm, and cerium oxide powder having a purity of 99.9% and an average particle size of 0.2 μm were mixed in a molar ratio of 2.94:5.5:0.06, yielding 1,000 g of a powder mixture.

The resulting powder mixture, 1,000 g, was mixed with 3,000 g of deionized water, granulated by a granulator, and fired, obtaining a granulated powder having an average particle size of 20 μm. The granulated powder was melted in an argon plasma and solidified. The resulting powder was heated in a reducing atmosphere consisting of 5 vol% of hydrogen and 95 vol% of argon at 1,500°C for 2 hours, yielding phosphor particles.

The phosphor particles were measured for absorptivity, internal quantum efficiency, external quantum efficiency, and chromaticity (x and y) by a quantum efficiency measuring system QE1100 (Otsuka Electronics Co., Ltd.) using excitation light 450 nm, emission spectrum of 480 to 740 nm and an integrating hemisphere. The measurement results are shown in Table 1, indicating a larger particle size and lower phosphor properties than Example 2.

**Table 1**

| | | Average particle size ($\mu$m) | Absorptivity (-) | Internal OE | External QE (-) | Chromaticity | |
|---|---|---|---|---|---|---|---|
| | | | | | | x | y |
| Example | 1 | 16.6 | 0.941 | 0.978 | 0.920 | 0.446 | 0.537 |
| | 2 | 14.8 | 0.930 | 0.970 | 0.902 | 0.377 | 0.566 |
| Comparative Example | 1 | 15.8 | 0.940 | 0.952 | 0.895 | 0.445 | 0.538 |
| | 2 | 20.5 | 0.905 | 0.922 | 0.834 | 0.379 | 0.565 |

**Claims**

1. A method for preparing a precursor to a phosphor, said phosphor comprising a garnet phase of the compositional formula (1):

$$(A_{1-x}B_x)_3C_5O_{12} \qquad (1)$$

wherein A is at least one rare earth element selected from the group consisting of Y, Gd, and Lu, B is Ce and/or Tb, C is Al and/or Ga, and $0.002 \leq x \leq 0.2$, the method comprising the steps of:

suspending gamma-alumina particles having a BET specific surface area of at least 50 $m^2$/g and dissolving a rare earth element salt in water to form a suspended aqueous solution,
adding urea to the suspended aqueous solution,
heating the solution to form mixed fine particles of gamma-alumina and rare earth element salt,
separating the mixed fine particles from the solution after heating, and
firing the mixed fine particles at a temperature of up to 1,000°C to form mixed oxide fine particles of rare earth oxide and alumina.

2. The method of claim 1 wherein the rare earth element salt used in the dissolving step contains a salt of at least one rare earth element selected from Y, Gd and Lu and a salt of Ce and/or Tb.

3. The method of claim 2 wherein the rare earth element salt used in the dissolving step further contains a salt of Ga.

4. The method of claim 1, 2 or 3 wherein in formula (1), C is Al and optionally also Ga.

5. A method for preparing a phosphor, comprising the steps of:

combining the mixed oxide fine particles prepared by the method of any one of claims 1 to 4 with a flux, and
heating the resulting mixture in a reducing atmosphere at a temperature of 1,300 to 1,500°C.

6. A method for preparing a phosphor, comprising the steps of:

granulating the mixed oxide fine particles prepared by the method of any one of claims 1 to 4.
melting the resulting granules in plasma and solidifying, and
heating the resulting particles in a reducing atmosphere.

7. A wavelength converter comprising the phosphor obtained by the method of claim 5 or 6 and an organic resin, in admixture.

FIG.1C

FIG.1A

FIG.1B

EP 2 690 154 A1

FIG.2A

FIG.2B

FIG.2C

Europäisches
Patentamt

European
Patent Office

Office européen
des brevets

## EUROPEAN SEARCH REPORT

Application Number

EP 13 17 7462

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2011/227477 A1 (ZHANG BIN [US] ET AL) 22 September 2011 (2011-09-22) * page 3 - page 7; examples * | 7 | INV. C09K11/77 |
| X | EP 0 889 005 A1 (SHINETSU CHEMICAL CO [JP]) 7 January 1999 (1999-01-07) * column 2 - column 4; examples * | 1-6 | |
| X | WO 2004/041964 A1 (OXONICA LTD [GB]; HOLLAND EDWARD ROBERT [GB]; HARRIS CHRISTOPHER GEORG) 21 May 2004 (2004-05-21) * page 4 - page 11; examples * | 1-6 | |
| X | CN 101 456 570 B (UNIV SHANGHAI JIAOTONG [CN] UNIV SHANGHAI JIAOTONG) 15 December 2010 (2010-12-15) * paragraph [0006] - paragraph [0021]; examples * | 1-6 | |
|  |  |  | TECHNICAL FIELDS SEARCHED (IPC) |
|  |  |  | C09K |

The present search report has been drawn up for all claims

| Place of search | Date of completion of the search | Examiner |
|---|---|---|
| Munich | 6 September 2013 | Doslik, Natasa |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

EP 2 690 154 A1

**ANNEX TO THE EUROPEAN SEARCH REPORT
ON EUROPEAN PATENT APPLICATION NO.**

EP 13 17 7462

This annex lists the patent family members relating to the patent documents cited in the above-mentioned European search report.
The members are as contained in the European Patent Office EDP file on
The European Patent Office is in no way liable for these particulars which are merely given for the purpose of information.

06-09-2013

| Patent document cited in search report | | Publication date | Patent family member(s) | | Publication date |
|---|---|---|---|---|---|
| US 2011227477 | A1 | 22-09-2011 | JP | 2013526007 A | 20-06-2013 |
| | | | TW | 201139621 A | 16-11-2011 |
| | | | US | 2011227477 A1 | 22-09-2011 |
| | | | WO | 2011115820 A1 | 22-09-2011 |
| EP 0889005 | A1 | 07-01-1999 | DE | 69802471 D1 | 20-12-2001 |
| | | | DE | 69802471 T2 | 04-04-2002 |
| | | | EP | 0889005 A1 | 07-01-1999 |
| | | | JP | H1121124 A | 26-01-1999 |
| | | | US | 6080485 A | 27-06-2000 |
| WO 2004041964 | A1 | 21-05-2004 | AU | 2003276428 A1 | 07-06-2004 |
| | | | WO | 2004041964 A1 | 21-05-2004 |
| CN 101456570 | B | 15-12-2010 | NONE | | |

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 3700502 B
- JP 2005008844 A